# EUROPEAN PATENT APPLICATION

(11) **EP 3 480 585 A1**
(43) Date of publication of application: **08.05.2019**
(21) Application number: 17200285.9
(22) Date of filing: 07.11.2017
(51) Int. Cl.: G01N 21/84, G01N 21/956

(54) **STENCIL INSPECTION BY MEANS OF A SOLDER PASTE INSPECTION DEVICE**

(71) Applicant: ASM Assembly Systems GmbH & Co. KG, 81379 München (DE)
(72) Inventor: Greer, Mathew, Glenrothes, KY75DZ (GB)
(74) Representative: Dilg, Haeusler, Schindelmann Patentanwaltsgesellschaft mbH

(57) **Abstract**

It is described a solder paste inspection device (100) for inspecting solder paste deposits (490) which have been applied onto a component carrier (190). The solder paste inspection device (100) comprises (a) a frame structure (102); (b) a first receiving structure (110) for temporarily receiving a component carrier (190), wherein the first receiving structure (110) is mounted to the frame structure (102); (c) a second receiving structure (120) for temporarily receiving a stencil (180) being used for applying solder paste deposits (490) onto a component carrier (190), wherein the second receiving structure (120) is mounted to the frame structure (102); (d) an optical inspection system (130) for inspecting the solder paste deposits (490) and for inspecting the stencil (180); and (e) a data processing unit (140) which is configured for determining at least one characteristic feature of the inspected stencil (180) and for outputting an information being indicative for the characteristic feature.

## Description

### Field of invention

The present invention generally relates to the technical field of manufacturing electronic assemblies, which comprise a component carrier and at least one electronic component being mounted on the component carrier and being electrically connected by means of an appropriate wiring structure. More specifically, the present invention relates to the technical field of applying solder paste deposits onto a component carrier with the help of a stencil, wherein the size and the shape of the solder paste deposits depend on apertures being formed within the stencil. In particular, the present invention relates to an optical inspection for determining the current state of such a stencil.

### Art Background

The automatic production of electronic assemblies typically starts with a printing process, wherein an appropriate amount of solder paste is transferred to or applied at predefined locations on a component carrier, in particular on a printed circuit board (PCB). These locations represent connection pads for terminals of electronic components which are mounted to the component carrier by means of a surface mount placement process, e.g. a so called pick and place process carried out by an automatic placement machine. Later, the electronic components are secured and electrically connected by means of a soldering procedure which can be carried out e.g. within a reflow oven.

The reliability of automatic electronic assembly production inter alia strongly depends on the quality of the solder paste printing. Specifically, it is important that a correct amount of solder paste is transferred to the connection pads in order to ensure that on the one hand there is available a sufficient amount of solder paste for the soldering procedure and on the other hand there is not too much solder paste present which may cause short circuits.

In order to ensure that a placement process (and a later soldering process) are only carried out with properly printed component carriers it is known to check the quality of a solder paste print process by means of an automated optical inspection. Dedicated machines have been developed in order to measure e.g. the shapes, the volumes, the positions, etc. of at least some solder paste deposits on the component carrier.

Solder paste printing is a process by means of which the viscous medium solder paste is first deposited within openings or apertures of a stencil being located on a component carrier. The configuration of the stencil apertures determines the basic layout of the deposits. For the printing process the stencil is aligned to the component carrier and then brought in close to or in direct contact with the surface of the component carrier. An angled blade, called a squeegee, is then used to drive the solder paste across the surface of the stencil at a controlled speed and force. As a result of such a print stoke the apertures on the stencil are filled with the solder paste. In a second step, when the stencil is removed from the component carrier, the contents of the filled apertures are transferred to the component carrier, thereby forming solder paste deposits. With one print stroke, thousands of solder paste deposits can be placed onto the surface of the component carrier. After one solder paste printing process the process can be repeated thousands of times with the same stencil onto further component carriers.

The quality of electronic assembly production strongly depends on the quality of the employed solder paste printing process. In turn, the quality of solder paste printing strongly depends on the current quality of the stencil. In particular due to mechanical wear or degradation the quality of a stencil decreases during a plurality of printing procedures. Therefore, it is necessary to determine the quality of a stencil from time to time and, when the quality is considered as to be not sufficient, replace the stencil with a new one. Further, an inspection of a stencil may also be useful before taking a stencil in operation in order to determine the quality of the (new) stencil and/or in order to check the type of stencil (for avoiding the use of a wrong stencil).

There may be a need for determining the current quality of a stencil which is supposed to be used for solder paste printing.

### Summary of the Invention

This need may be met by the subject matter according to the independent claims. Advantageous embodiments of the present invention are described by the dependent claims.

According to a first aspect of the invention there is provided a solder paste inspection device for inspecting solder paste deposits which have been applied onto a component carrier. The provided solder paste inspection device comprises (a) a frame structure; (b) a first receiving structure for temporarily receiving a component carrier, wherein the first receiving structure is mounted (directly or indirectly) to the frame structure; (c) a second receiving structure for temporarily receiving a stencil being used for applying solder paste deposits onto a component carrier, wherein the second receiving structure is mounted (directly or indirectly) to the frame structure; (d) an optical inspection system for inspecting the solder paste deposits and for inspecting the stencil; and (e) a data processing unit which is communicatively connected to the optical inspection system and which is configured for (e1) determining at least one characteristic feature of the inspected stencil and for (e2) outputting an information being indicative for the characteristic feature.

The described solder paste inspection (SPI) device is based on the idea that by providing appropriate modifications to a known the SPI system such a system can, in addition to its usual functionality, also be used for determining the actual or current quality or state of a stencil which is used in a solder paste printer. Since in a typical production line for electronic assemblies, with respect to the transport direction through the production line, a solder paste printer is placed (directly) upstream of an SPI system, an SPI system being modified in accordance with the invention and resulting in the described SPI device may be located nearby such that the effort for performing a stencil inspection is quite low. Specifically, a transfer between the solder paste printer and the described SPI device can be carried out very fast. This means that for performing a stencil inspection the operation of the solder paste printer only has to be interrupted for a short amount of time.

The optical inspection system may be any system which is capable for taking or for capturing images of a received component carrier as well as a received stencil. The optical inspection system may comprise a camera such as a CCD camera. The camera may be a black and white camera or alternatively a color camera, wherein the latter allows to obtain more detailed information about (the surface of) the stencil. Further, the optical inspection system may comprise an illumination unit such that the camera can capture high-quality images or pictures of the stencil in a bright environment. An illumination of the stencil to be inspected may be realized with a flash-like operation of the illumination unit which may allow for a very bright illumination (with a high light intensity). Of course, in this case the operation of the camera and the operation of the illumination unit have to be synchronized with each other.

The mentioned transfer between the solder paste printer and the described solder paste inspection device can be carried out manually by means of an operator and/or automatically by means of an appropriate robot system.

The mentioned characteristic feature of the stencil may be any general or local feature which has an impact on the solder paste printing quality. The characteristic feature may be (i) a structural feature which is characteristic for the type of stencil and which can be considered as to be a permanent stencil feature and/or (ii) a feature or a characteristic being indicative for a wear or degradation state of the stencil, which feature or characteristic changes during operation or use of the stencil.

The output information could be any information which can be used e.g. by an operator for deciding about the further use of the stencil. In particular, the output information could represent warning for an operator not to use the respective stencil for further solder paste printing.

According to an embodiment of the invention the second receiving structure comprises guiding means which are configured for guiding in a spatially defined manner (i) a stencil to be inspected towards a predefined inspection position and/or (ii) a stencil which has already been inspected away from the predefined inspection position. Thereby, the predefined inspection position is a position for the stencil which is located in a field of view of the optical inspection system. This may provide the advantage that a wrong insertion of the stencil to be inspected can be prevented. As a result the operational reliability of the described SPI device can be increased in a simple and effective manner.

Specifically, with the guiding means it can be prevented that the stencil to be inspected is brought into a wrong position (within the solder paste inspection device) wherein the optical inspection is not reliable. Further, a collision between the stencil and (potentially sensitive) components of the SPI device can be prevented such that also an unintentional damage of the SPI device (e.g. because of an un-careful operator) can be effectively prevented. Of course also collisions which might occur when removing the (already inspected) stencil can be effectively prevented with the described guiding means.

The described guiding means may enforce a transfer of the stencil to and/or from the inspection position along a predefined track, preferably along straight line of stencil transfer. The direction of the transfer line may be angular and more preferably perpendicular to a transport direction for printed component carriers. In an entire production line for electronic assemblies this transport direction may be defined by the transport path along which the component carriers are transported through the various machines (e.g. solder paste printer, automated placement machine, etc.) being used for the electronic assembly production.

According to a further embodiment of the invention the guiding means are configured for bringing the stencil into the inspection position along a stencil transport path and for removing the stencil from the inspection position along the same stencil transport path.

Descriptively speaking, when removing a stencil, which has already been inspected, from the inspection position this stencil has to be moved along the same path as it has been transferred into the inspection position (before having been inspected by the optical inspection system). Specifically, the stencil may be inserted into the solder paste inspection device from one side and may be removed from the solder paste inspection device at the same side. Such a configuration allows to realize the solder paste inspection device in a spatially compact manner. Further, a handling of stencils by means of an operator may be facilitated.

According to a further embodiment of the invention the second receiving structure comprises at least one stopping element and/or at least one mechanical clamp for spatially positioning and/or keeping the stencil in a proper position for being inspected by means of the optical inspection system.

Proper positioning the stencil for and during the optical inspection may allow for a particular reliable optical inspection of the stencil. The risk of attributing wrong characteristic features to the stencil may be significantly reduced.

The stopping element may be any physical structure which defines a stop position for the stencil which has been inserted into the described SPI device. The mechanical clamp may be any physical structure which is capable of maintaining the stencil, once being brought into the correct position, in this correct position. Of course, the mechanical clamp should be configured for fixing the stencil at its position in a releasable manner. After finishing the optical inspection the stencil can be easily removed from its position (within the SPI device) for further use (in a solder paste printer) or for disposal (in case the stencil is not good enough anymore).

It is mentioned that in accordance with known SPI systems the first receiving structure may not be equipped with a mechanical clamp and in particular not with a stopping element. This is because a transport path for the component carriers extends through the entire SPI device, i.e. a component carrier enters the SPI device from one side and leaves the SPI device at another opposing side. A proper positioning of a component carrier can be ensured by controlling the operation of a transport device, e.g. a conveyor belt, in a proper manner such that for optical inspection of the component carrier the transport device is stopped temporarily at a proper position.

According to a further embodiment of the invention (a) the first receiving structure is configured such that a received component carrier is located at first height level with respect to the frame structure and (b) the second receiving structure is configured such that a received stencil is located at a second height level with respect to the frame structure. Thereby, the second height level is different from the first height level. In particular, the second height level is higher than the first height level.

Designing the receiving structures that the component carrier and the stencil are received at different heights may provide the advantage that the described SPI device can be realized by a comparatively simple modification of a known SPI system. In particular, it will not be necessary to modify all those mechanical components which are used for transporting the component carrier through the SPI device.

It is mentioned that the term "first height level" and second "height level" may refer to a direction which corresponds to the vertical direction. Thereby, the term "vertical direction" direction refers to an orientation of the described SPI device when being set up (within an electronic assembly production line).

The difference in the height levels may be more that 2 mm. This difference is preferably more than 5 mm and even more preferably more than 10 mm. These spatial configurations may provide the advantage that the second receiving structure can be used independently from the operation respectively from the use of the first receiving structure (which may be a transport system). In other words, also during an inspection of a stencil component carriers can still be transported through the SPI device. Of course, an SPI of the respective component carriers may be limited.

Further, the difference in the height levels may be less than 50 mm. The difference may be preferably less than 40 mm and more preferably less than 30 mm. All these spatial configurations may allow to realize the described solder paste inspection device within a compact design.

According to a further embodiment of the invention the second receiving structure is configured for receiving the stencil both in a first orientation and in a second orientation. Thereby, with regard the first orientation the second orientation is an upside down orientation. This may provide the advantage that the stencil can be optically inspected not only from an upper side but also from the opposite lower side.

The upper side may be the side at which the squeegee distributes the solder paste over the surface of the stencil and at which the squeegee transfers the solder paste into the apertures of the stencil. The upper side may also be denominated as the squeegee side. The lower side may be the side which during the printing process is placed onto the surface of the respective component carrier. Therefore, the lower side may also be denominated as the component carrier or as the PCB side.

It is mentioned that a typical stencil comprises a metal foil (with the apertures) and a frame which supports respectively spans or chucks the metal foil. With respect to a direction being perpendicular to the surface of the metal foil, i.e. with respect to the normal direction of the surface of the metal foil, the design of the stencil is not symmetric. Specifically, the metal foil is attached to the frame at a lower (or upper) side of the frame. The described second receiving structure should be configured in order to take into account this stencil asymmetry wherein with respect to the thickness direction of the frame (i.e. perpendicular to the surface of the metal foil) the metal foil is not attached in the middle of the frame.

According to a further embodiment of the invention the optical inspection system comprises a focusing lens system with an adaptive focal length. This may provide the advantage that not only the component carrier but also stencils, which during inspection are located at a different distance from the optical inspection system, can be inspected with a high precision. A high optical precision can be realized by setting the focusing lens system to a first focal length for inspecting a printed component carrier and by setting the focusing lens system to the second focal length for inspecting for inspecting a stencil.

According to a further embodiment of the invention the characteristic feature is indicative for at least one of (i) a design of the stencil, (ii) a state of degradation of the stencil, and (iii) a contamination of the stencil.

Checking the design of the stencil may allow to identify the type of stencil which itself may allow to guarantee that for a certain printing procedure the correct stencil is used. Checking the state of degradation of the stencil may allow to prohibit this stencil from being used in further printing processes such that with a new stencil a high printing quality can be guaranteed. Checking a contamination of the stencil, in particular a contamination with residuals of solder paste, can be helpful in order to decide when the stencil should be cleaned, in particular with an extensive cleaning procedure which goes beyond the usual cleaning procedures with which the stencils are cleaned e.g. by means of wiping and which are typically accomplished within a solder paste printer.

According to a further embodiment of the invention the characteristic feature is the area ratio of at least one aperture of the stencil.

The area ratio of an aperture within a stencil is defined in a known manner by the ratio between (a) the opening area of the aperture and (b) the surface of the inner wall of the stencil, which defines the aperture. In this respect it is recalled that in a printing process an aperture within a stencil being located directly onto a component carrier is first used to accommodate a certain amount or volume of solder paste. When, after the aperture has been filled with solder paste, the component carrier is removed from the stencil, the solder paste is supposed to adhere to the respective connection pad of the component carrier. At least the solder paste should adhere better to the component carrier as to the stencil. In this respect it is clear, that a transfer of solder paste by means of small stencil aperture and in particular by a stencil aperture which has a small area ratio is more error-prone as compared to a transfer of solder paste by means of a large stencil aperture and in particular by a stencil aperture which has a large area ratio. Based on these well-known considerations on "area ratio" it should be clear that with a large area ratio the printing process will be more stable than with a small area ratio. As a consequence, the so-called repeatability of the printing process will be improved when apertures with a large area ratio are used.

It is mentioned that in the field of solder paste printing it is well known to calculate, based on an appropriate image of a stencil, the important parameter "area ratio". Therefore, in this document it is refrained from describing usual area ratio calculation procedures which can be applied by the data processing unit. It is further mentioned that the stencil parameter "area ratio" is not only relevant for the (original) design of the stencil but can also undergo a change during a degradation respectively wear of the stencil.

According to a further embodiment of the invention the characteristic feature is a state of wear of a nano-coating of at least a surface portion of the stencil.

A nano-coating is a surface treatment or surface modification of the metal foil of a stencil which in a known manner is used for preventing an unwanted adhesion of solder paste material. Thereby, benefit is taken from the so-called lotus effect causing a self-cleaning of a corresponding surface. Nano-coating is typically applied on the bottom or PCB side of the stencil and/or at the inner sidewalls of the apertures wherein an unwanted adhesion of solder paste may otherwise occur.

It should be clear that a nano-coating is a surface which is subjected (to a large extent) to degradation. In this context the inventor found out, that the state of degradation of a nano-coating has a strong impact on the color with which the nano-coating appears in an image of the stencil. In other words, the color of the nano coating is indicative for the state of degradation. In addition to this finding the inventor found out, that the nano-coating degradation state can best be determined when a color or black and white camera in connection with a so called multi-color illumination unit is employed, such that an optimal spectral distribution of illumination light can be selected for the nano-coating illumination. Probably, the most precise determination of a nano-coating degradation can be realized when at least two images of the nano-coating are captured under different spectral illuminations and the (color) information in both pictures is used.

According to a further embodiment of the invention the data processing unit is configured for (a) comparing a first image of the component carrier captured by the optical inspection system with a second image of the stencil also captured by the optical inspection system, and (b) determining a spatial mapping between at least one connection pad and at least one corresponding aperture of the stencil. This may provide the advantage that by means of the so called mapping factor an overall alignment between (an entirety of) connection pads of the component and (an entirety) of apertures of the stencil can be determined respectively judged. Thereby, different weighting factors can be assigned to different regions of the stencil respectively the component carrier. For example a region with smaller and/or more densely arranged connection pads may be attributed with a different weighting factor than a region with larger and/or spatially more separated connection pads.

It is mentioned that such a mapping should preferably be performed with an "empty" component carrier, i.e. a component carrier which has not yet been provided with printed solder paste material.

According to a further embodiment of the invention the optical inspection system is configured for performing a 3D inspection and the data processing device is configured for performing a topology inspection of at least one of (i) the upper surface of the component carrier, (ii) the upper surface of the stencil, and (iii) the bottom surface of the stencil. The use of a 3D (three dimensional) inspection may provide the advantage that not only the solder paste deposits on the component carrier but also the (at last one) characteristic feature of the inspected stencil can be determined precisely and with a high reliability.

For realizing a 3D inspection depending on the specific use case one or more of 3D inspection principles may be used. Usual 3D inspection principles may be e.g. triangulation, structured light scanning, and/or photometric stereo. These techniques are known in the field of 3D inspection. For the sake of conciseness of this document they will not be elucidated here.

The upper surface of the component carrier may be defined, at least within a predetermined region around a connection pad, by the upper surface of a solder (resist) mask. An important information about the upper surface of the component carrier may also be given by the height difference between the upper level of the solder (resist) mask and the upper level of the connection pad.

It should be clear, that when both the topology of the upper surface of the component carrier and the topology of the lower surface of the component carrier is to be determined a flipping of the stencil will be necessary. Such a flipping (upside down) of the stencil has already been elucidated above.

In particular with a topology inspection of the upper surface of the stencil so called "surface steps" formed at the upper side of the stencil can be determined. Of course, not only the design of a stencil with a step but also a state of degradation of such a step within the surface of the stencil can be determined. Such a degradation will typically result in a pounding of at least one edge of the stepped surface.

It is mentioned, that steps on the stencil surface (which are associated with a thickness step of the stencil) are used for realizing, (i) in a thicker region of the stencil, a thicker solder paste deposition, and (ii) in a thinner region of the stencil, a thinner solder paste deposition. Of course, also a thickness variation of the stencil respectively of the metal foil of the stencil can be identified.

According to a further embodiment of the invention the SPI device further comprises a communication device which is configured (a) for receiving information from a data memory provided at the stencil wherein determining the characteristic feature depends on the information being received; and/or (b) for transmitting information to a data memory provided at the stencil, wherein the information is indicative for the determined at least one characteristic feature.

This may provide the advantage that a traceability of solder paste printing can be realized wherein the traceability includes in particular a knowledge about which individual stencil has been used for producing a certain electronic assembly. Further, wrong and/or degraded stencils for a certain printing procedure may be identified. By means of an appropriate "veto procedure" is can be prevented that such a stencil is used or inserted into a solder paste printer.

According to a further aspect of the invention there is provided a method for determining at least one characteristic feature of a stencil. The provided method comprises (a) transferring the stencil to a solder paste inspection device as described above; (b) inspecting the stencil with the optical inspection system; (c) determining the at least one characteristic feature of the inspected stencil by means of the data processing unit; and (d) removing the stencil from the solder paste inspection device.

Also the described method is based on the idea that most functionality being necessary for performing an optical stencil inspection is already provided by a known SPI system. Therefore, only some structural modifications (as described above) to a known SPI system and a corresponding software for the data processing unit are necessary in order to allow for both an optical inspection of component carriers and an optical inspection of stencils.

As has already been mentioned above, the steps of transferring the stencil and of removing the stencil can be carried out manually by means of an operator and/or at least partially automatically by means of an appropriate robot system.

According to a further aspect of the invention there is provided a use of an SPI device, in particular an SPI device as described above, for determining at least one characteristic feature of a stencil for (a) printing solder paste material onto a component carrier and (b) outputting an information being indicative for the determined characteristic feature.

It has to be noted, that embodiments of the invention have been described with reference to different subject matters. In particular, some embodiments have been described with reference to apparatus type claims whereas other embodiments have been described with reference to a method or a use type claim. However, a person skilled in the art will gather from the above and the following description that, unless other notified, in addition to any combination of features belonging to one type of subject matter also any combination between features relating to different subject matters is to be considered as to be disclosed with this document.

The aspects defined above and further aspects of the present invention are apparent from the examples of embodiments to be described hereinafter and are explained with reference to the examples of embodiment. The invention will be described in more detail hereinafter with reference to examples of embodiments but to which the invention is not limited.

### Brief Description of the Drawing

Figure 1 shows in a cross sectional view a solder paste inspection (SPI) device for inspecting both a component carrier and a stencil.
Figure 2 shows a top view of the SPI device.
Figure 3 shows various optical components of an optical inspection system of the SPI device shown in Figure 1.
Figures 4a and 4b illustrate the effect of a misalignment between an aperture of a stencil and a connection pad of a component carrier when performing a solder paste printing.

### Detailed Description

The illustration in the drawing is schematic. It is noted, that in different figures, similar or identical elements or features are provided with the same reference signs. In order to avoid unnecessary repetitions elements or features which have already been elucidated with respect to a previously described embodiment are not elucidated again at a later position of the description.

Further, spatially relative terms, such as "front" and "back", "above" and "below", "left" and "right", et cetera are used to describe an element's relationship to another element(s) as illustrated in the figures. Thus, the spatially relative terms may apply to orientations in use which may differ from the orientation depicted in the Figures.

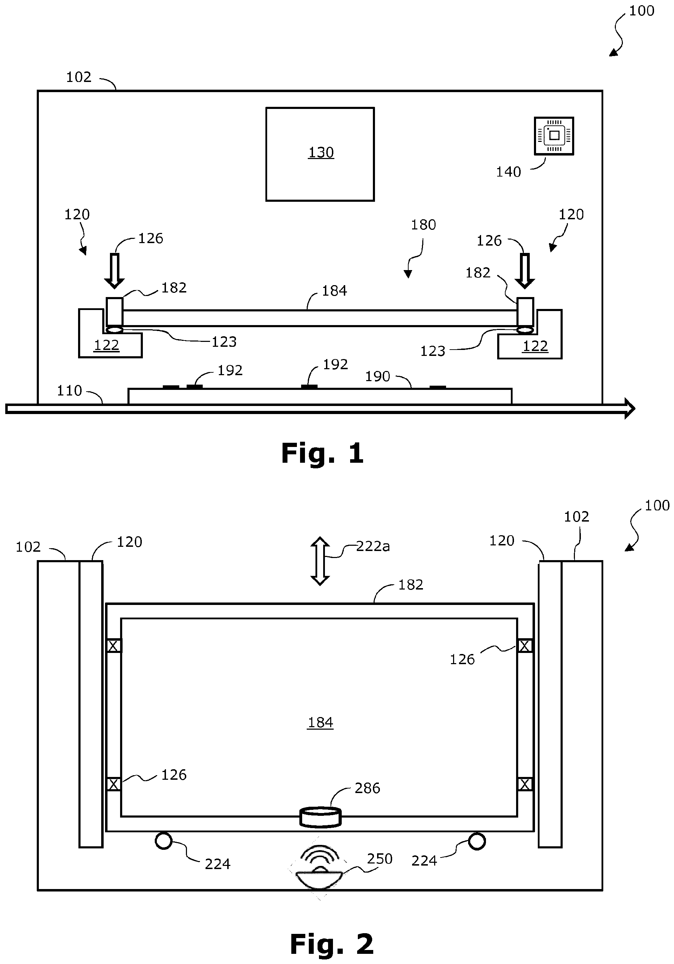

Figures 1 and 2 show a solder paste inspection (SPI) device 100 in accordance with an embodiment of the invention. Figure 1 shows the SPI device 100 in a cross-sectional view whereas Figure 2 shows the SPI device 100 in a top view.

As can be taken best from Figure 1, the SPI device 100 comprises a frame structure 102. At the frame structure 102 there are mounted in a non-depicted manner a first receiving structure 110 and, at a higher height level, a second receiving structure 120.

The first receiving structure 110 is configured for receiving respectively holding in place (in a known manner) a component carrier 190. The component carrier 190 comprises connection pads 192, onto which solder paste (not depicted in Figures 1 and 2) has been transferred in a previous step by means of a so-called solder paste printer. The process of printing the solder paste onto the connection pads 192 is known in the field of manufacturing electronic assemblies and will not be elucidated in this document.

According to the embodiment described here the first receiving structure 110 is realized simply by a section of a transport system which extends not only through the SPI device 100 but also along the transport path of an entire electronic assembly production line, which apart from the described SPI device 100 comprises inter alia at least one automatic placement machine.

The SPI device 100 comprises an optical inspection system 130 which is arranged and configured for performing an optical inspection of solder paste deposits which have been printed onto the connection pads 192. A data processing system 140, which is communicatively connected to the optical inspection system 113, is programmed to perform the necessary calculations for determining the 3D spatial shape of the solder paste deposits. Thereby, it can be checked whether in the previous printing process a correct amount of solder paste has been applied onto the correct location (directly on the respective connection pad 192). The principles of SPI are known to the skilled person and will not be described here in more detail.

The second receiving structure 120 is configured for receiving a stencil 180 which is supposed to be optically inspected also by means of the optical inspection system 130. Such a stencil 180 comprises a frame 182 and a metal foil 184, within which (in Figure 1) non-depicted apertures are formed. The frame 182 supports, holds, or spans the metal foil 184. The general structure of the stencil 180 is known to the skilled person and will not be described here in more detail.

According to the embodiment described here the second receiving structure 120 is realized by means of an L-shaped guiding means 122, along which the stencil 180 to be inspected can be inserted in the SPI device 100. In order allow for a smooth insertion on the lower "leg" of the "L" there is provided a sliding bearing 123, onto which the bottom surface of the frame 182 smoothly slides along a direction being perpendicular to the plane of drawing of Figure 1.

As can be seen from Figure 2, the second receiving structure 122 further comprises stopping elements 224. These stopping elements 224 are also mounted to the frame structure 102. The locations of the stopping elements 224 are chosen such that when an inserted stencil 180 reaches or abuts the stopping elements 224 the stencil 180 will be in the proper position for optical inspection by means of the optical inspection system 130. It should be clear that in the top view of Figure 2 the direction of insertion corresponds to the vertical direction of the Figure. In order to make this 100% clear the direction of insertion (and also the direction of removal) of the stencil 180 is indicated by a double arrow 222a.

As can be seen in both Figures 1 and 2, the second receiving structure 120 further comprises mechanical clamps 126, which are used for detachably securing the stencil 180 in its inspection position, which (along the horizontal direction) is defined by the stopping elements 224. According to the embodiment described here the mechanical clamps provide a pressure onto the frame 182 of the stencil 180 thereby pressing the frame 182 onto the lower "leg" of the "L" of the guiding means 122. It should be clear that of course any other mechanical construction for temporally securing the stencil 180 in its inspection position can be used.

According to the embodiment described here the data respectively image processing of images of the stencil 180 and in particular of the metal foil 184, which images have been captured by the optical inspection system 130, is also accomplished by the data processing system 140. This provides the advantage that the stencil inspection functionality of the SPI device 100 can be realized with only minor modifications of a known SPI system which is only used for inspecting solder paste deposits on to the connection pads 192. These minor modifications include structural modifications which are related to the handling of the stencil 180 by means of inter alia the second receiving structure 120. With regard to the optical inspection compared to a known SPI system the same components can be used. Only a re-programming of the data processing system 140 may be necessary.

According to the embodiment described here, the SPI device 100 is further capable of performing a so-called traceability of stencils 180 which are inspected. For this purpose the SPI device 100 comprises a communication device 250, which is configured for communicating with a data memory 286 of the stencil 180. The data memory 286 may be provided at (the frame 182 of) the stencil 180. The communication may be realized for instance by means of Near Field Communication (NFC). In this case the communication device 250 may be a NFC reader / writer and the data memory 286 may be equipped with a NFC device such as a RFID tag. Benefits of a stencil traceability are described above.

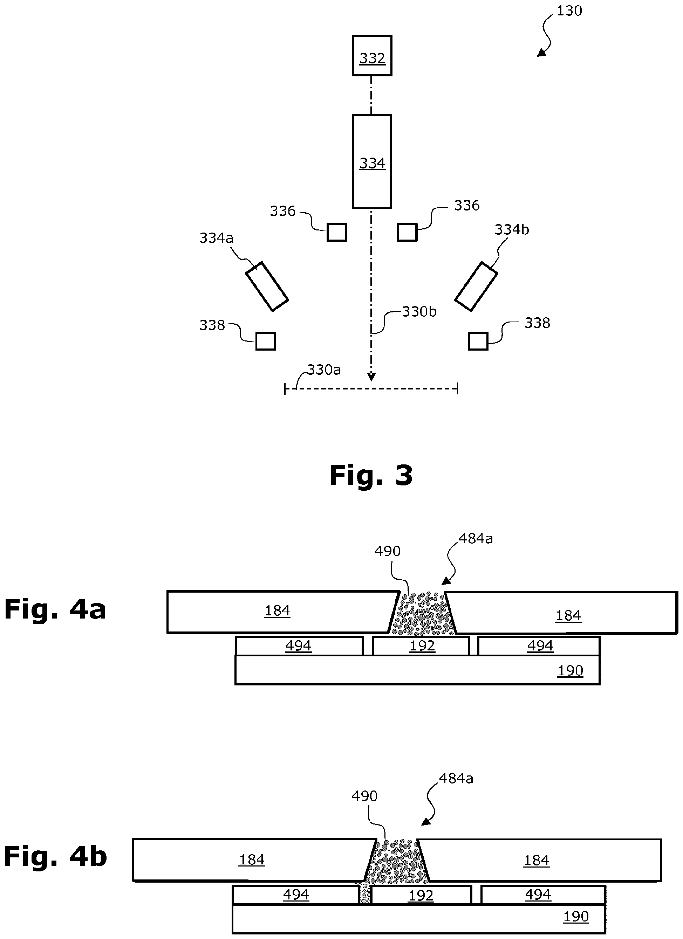

Figure 3 shows a possible realization of the optical inspection system 130. According to the embodiment described here, the optical inspection system 130 comprises a camera 332, which may be for instance a black-and-white or alternatively a color CCD camera. A focusing lens system 334 of the optical inspection system 130 is configured for changing the position of the focal plane of the camera 332 in order to allow the camera to capture sharp images of both the stencil 180 (when being in the inspection position) and the component carrier 190 (when the stencil 180 is not present in its inspection position). According to the embodiment described here, the focusing lens system 334 is configured not only for focusing two planes having different height positions. As has already mentioned above the stencil 180 can be received by the second receiving structure 120 not only in the orientation as depicted in Figure 1 but also in an upside down orientation. Due to an asymmetric design of the stencil along the vertical direction the height position of the metal foil 184 changes when flipping the stencil upside down. Therefore, the focusing lens system 334 is configured to focus the camera also on the metal foil 184 when the stencil is in its upside down orientation. The focusing lens system 334 may be a manual focus or an autofocus lens system. The camera 332 and the focusing lens system 334 together define an optical axis 330b and a field of view 330a.

According to the embodiment described here the optical inspection system 130 is capable of performing a 3D inspection. There are many possibilities for realizing a 3D inspection which are known to the skilled person. The optical inspection system 130 shown here is based on the so called triangulation principle. Therefore, in addition to the camera 332 there are provided tilt cameras 334a and 334b, which view the metal foil 184 of the stencil 180 and/or on the component carrier 190 along tilted directions (oblique with regard to the optical axis 330b). Of course, also the tilt cameras 334a and 334b may have a (not depicted) focal optic which allows capturing sharp images at different height levels.

In order to have clear images the optical inspection system 130 further comprises two illumination units which are realized by means of a first illumination ring 336 and a second illumination ring 338. The illumination rings 336 and 338 are arranged concentrically around the optical axis 330b and allow an illumination under various illumination angles. According to the embodiment described here both illumination rings 336 and 338 are capable of providing illumination light with a certain spectral composition. The spectral compositions may be the same or different. Further, at least one of the illumination rings 336 and 338 may be configured for emitting at least two illuminations having different spectral compositions. This may provide the advantage that the spectral composition of the illumination light can be selected such that the cameras 332, 334a and/or 334b capture images in or on which the structures of interest are best visible. This can be realized best if the cameras 332, 334a and/or 334b are color cameras.

Figures 4a and 4b illustrate a solder paste printing procedure when there is a misalignment between an aperture 484 of a stencil formed in the metal foil 184 of the stencil 180 and a corresponding connection pad 192 of a component carrier 190. In these Figures the component carrier 190 is depicted together with the connection pad 192 and with the layer of a solder resist mask 494 which is formed around the connection pads 192. Figure 4a shows the printing procedure for a perfect alignment between the aperture 484 and the connection pad 192. Solder paste 490 will only be applied on top of the connection pad 192. Figure 4b shows the printing procedure in case of a misalignment between the aperture 484 and the connection pad 192. As a result of the misalignment solder paste 490 also enters the region between the connection pads 192 and the solder resist mask 494.

One important advantage of the SPI device 100 described here is that with one and the same device a spatial mapping between connection pads 192 and the corresponding apertures 490 can be performed. Such a spatial mapping should preferably be performed with an "empty" component carrier which has not yet been provided with printed solder paste material. Descriptively speaking, with such a mapping it can be decided whether a certain stencil 180 for solder paste printing fits to certain type of component carrier 190 to be printed. If there is a high alignment between the entirety of apertures 484a and the entirety of corresponding connection pads 192 (i.e. a mapping factor is high) good solder paste printing results can be expected. On the contrary, if the there is a poor alignment (i.e. the mapping factor is small) another stencil should be used for realizing a better printing quality.

As has already been mentioned above, such a mapping procedure can be accomplished by means of the data processing unit 140 which compares a first image of the component carrier 190 with a second image of the stencil 180 wherein both images have been captured by (one and the same) optical inspection system 130.

It should be noted that the term "comprising" does not exclude other elements or steps and the use of articles "a" or "an" does not exclude a plurality. Also elements described in association with different embodiments may be combined.

It should also be noted, that reference signs in the claims should not be construed as limiting the scope of the claims.

### List of reference signs:

- 100: solder paste inspection (SPI) device
- 102: frame structure
- 110: first receiving structure / transport system
- 120: second receiving structure
- 122: guiding means
- 123: (sliding) bearing
- 126: mechanical clamp
- 130: optical inspection system
- 140: data processing system
- 180: stencil
- 182: frame
- 184: metal foil (with apertures)
- 190: component carrier / Printed Circuit Board (PCB)
- 192: connection pad
- 222a: direction of insertion and removal of stencil
- 224: stopping element
- 250: communication device
- 286: data memory / RFID chip
- 330a: field of view
- 330b: optical axis
- 332: camera
- 334a/b: tilt camera
- 334: focusing lens system
- 336: first illumination ring
- 338: second illumination ring
- 484a: aperture
- 490: solder paste
- 494: solder resist mask

## Claims

1. A solder paste inspection device (100) for inspecting solder paste deposits (490) which have been applied onto a component carrier (190), the solder paste inspection device (100) comprising
a frame structure (102);
a first receiving structure (110) for temporarily receiving a component carrier (190), wherein the first receiving structure (110) is mounted to the frame structure (102);
a second receiving structure (120) for temporarily receiving a stencil (180) being used for applying solder paste deposits (490) onto a component carrier (190), wherein the second receiving structure (120) is mounted to the frame structure (102);
an optical inspection system (130) for
inspecting the solder paste deposits (490) and
for inspecting the stencil (180); and
a data processing unit (140) which is communicatively connected to the optical inspection system (130) and which is configured for
determining at least one characteristic feature of the inspected stencil (180) and for
outputting an information being indicative for the characteristic feature.

2. The solder paste inspection device (100) as set forth in the preceding claim, wherein
the second receiving structure (120) comprises guiding means (122) which are configured for guiding in a spatially defined manner
(i) a stencil (180) to be inspected towards a predefined inspection position
and/or
(ii) a stencil (180) which has already been inspected away from the predefined inspection position, wherein
the predefined inspection position is a position for the stencil (180) which is located in a field of view (330a) of the optical inspection system (130).

3. The solder paste inspection device (100) as set forth in the preceding claim, wherein
the guiding means (122) are configured for bringing the stencil (180) into the inspection position along a stencil transport path and for removing the stencil (180) from the inspection position along the same stencil transport path.

4. The solder paste inspection device (100) as set forth in any one of the preceding claims, wherein
the second receiving structure (122) comprises at least one stopping element (224) and/or at least one mechanical clamp (126) for spatially positioning and/or keeping the stencil (180) in a proper position for being inspected by means of the optical inspection system (130).

5. The solder paste inspection device (100) as set forth in any one of the preceding claims, wherein
the first receiving structure (110) is configured such that a received component carrier (190) is located at a first height level with respect to the frame structure 102 and
the second receiving structure (120) is configured such that a received stencil (180) is located at a second height level with respect to the frame structure (102), wherein
the second height level is different from the first height level, in particular the second height level is higher than the first height level.

6. The solder paste inspection device (100) as set forth in any one of the preceding claims, wherein
the second receiving structure (120) is configured for receiving the stencil (180) both in a first orientation and in a second orientation, wherein with regard the first orientation the second orientation is an upside down orientation.

7. The solder paste inspection device (100) as set forth in any one of the preceding claims, wherein
the optical inspection system (130) comprises a focusing lens system (334) with an adaptive focal length.

8. The solder paste inspection device as set forth in any one of the preceding claims, wherein the characteristic feature is indicative for at least one of
a design of the stencil (180),
a state of degradation of the stencil (180), and
a contamination of the stencil (180).

9. The solder paste inspection device (100) as set forth in any one of the preceding claims, wherein the characteristic feature is
the area ratio of at least one aperture (484a) of the stencil (100).

10. The solder paste inspection device (100) as set forth in any one of the preceding claims, wherein the characteristic feature is
a state of wear of a nano-coating of at least a surface portion of the stencil (180).

11. The solder paste inspection device (100) as set forth in any one of the preceding claims, wherein
the data processing unit (140) is configured for
comparing a first image of the component carrier (190) captured by the optical inspection system (130) with a second image of the stencil (180) also captured by the optical inspection system (130), and
determining a spatial mapping between at least one connection pad (192) and at least one corresponding aperture (484a) of the stencil (180).

12. The solder paste inspection device (100) as set forth in any one of the preceding claims, wherein
the optical inspection system (130) is configured for performing a 3D inspection and
the data processing device (140) is configured for performing a topology inspection of at least one of
the upper surface of the component carrier (190),
the upper surface of the stencil (180), and
the bottom surface of the stencil (180).

13. The solder paste inspection device (180) as set forth in any one of the preceding claims, further comprising
a communication device (250) which is configured
for receiving information from a data memory (286) provided at the stencil (180) wherein determining the characteristic feature depends on the information being received; and/or
for transmitting information to a data memory (286) provided at the stencil (180) wherein determining the information is indicative for the determined at least one characteristic feature.

14. Method for determining at least one characteristic feature of a stencil (180), the method comprising
transferring the stencil (180) to a solder paste inspection device (100) as set forth in any one of the preceding claims;
inspecting the stencil (180) with the optical inspection system (130);
determining the at least one characteristic feature of the inspected stencil (180) by means of the data processing unit (140); and
removing the stencil (180) from the solder paste inspection device (100).

15. Use of a solder paste inspection device (100), in particular a solder paste inspection device (100) as set forth in any one of the preceding claims 1 to 13, for
determining at least one characteristic feature of a stencil (180) for printing solder paste material (490) onto a component carrier (190) and
outputting an information being indicative for the determined characteristic feature.
